# EUROPEAN PATENT APPLICATION

(11) **EP 2 763 184 A1**
(43) Date of publication of application: **06.08.2014**
(21) Application number: 12836775.2
(22) Date of filing: 26.09.2012
(51) Int. Cl.: H01L 31/0264

(54) **INKS FOR THE IN-SITU PRODUCTION OF CHALCOGENS AND/OR CHALCOGENIDES THAT FORM SEMICONDUCTOR LAYERS, PRODUCTION METHOD THEREOF AND USE OF SAME**

(30) Priority: 30.09.2011 ES 201131580
(71) Applicant: Universitat Jaume I De Castellón, 12006 - Castellón de la Plana (ES); Centre National de la Recherche Scientifique (CNRS), 75794 Paris Cedex 16 (FR); Electricité de France, 92141 Clamart Cedex (FR)
(72) Inventor: CARDÁ CASTELLÓ, Juan Bautista, E-12006 Castellón De La Plana (ES); ESCRIBANO LÓPEZ, Purificación, E-12006 Castellón De La Plana (ES); KRASSIMIROV TODOROV, Teodor, E-12006 Castellón De La Plana (ES); LINCOT, Daniel, F-92141 Clamart Cedex (FR); CHASSAING, Elisabeth, F-75794 Paris Cedex 16 (FR)
(74) Representative: Ungria López, Javier
(86) International application number: PCT/ES2012/070666
(87) International publication number: WO 2013/045731

(57) **Abstract**

The invention relates to an ink composition for the *in-situ* production of chalcogens and/or chalcogenides, characterised in that it comprises at least one chalcogenite compound having a formula selected from a group consisting of SeO₂, M(SO₃)ₙ, M(SeO₃)ₙ and M(TeO₃)ₙ, wherein 0.5≤n≤2 and M is at least one metal element. In addition, the invention relates to the inks produced using said composition, the production method thereof and the use of same for the *in-situ* preparation of semiconductor materials.

## Description

### Technical field

The present invention relates to ink compositions used for printing layers of compounds, mainly of selenium, known for their semiconductor properties. Of particular interest is their use in the mass production of low-cost photovoltaic devices.

### Background of the invention

The environmental consequences of fossil fuels usage and the economic repercussion associated with their depletion has made the introduction of renewable and clean energy sources an absolute necessity. The sun is a feasible source to satisfy our energy needs. The only limitation to large-scale photoelectric conversion that is sufficient for global consumption is the high cost and low production volume of photovoltaic panels.

Thin layer photovoltaic materials, for example chalcopyrites of the Cu(In,Ga)Se₂ (CIGS) type, are promising candidates for large-scale future production due to their high photoelectric efficiency, reaching 20 %, and excellent stability.

It is not known if the reduction of selenites, or other salts of elements in its group, after deposition has been described, despite its widespread use in methods for the deposition of selenide layers in different baths by chemical means (A. B. Kulkarni, et al., Thin Solid Films 260 (1995) 14-18) or by electrochemical means (D. Lincot, J. F. et al., Solar Energy, 77 (2004) 725-737D *and* US2006/0151331). The reduction of ZnSeO₄.H₂O and ZnSeO₃.H₂O in CO atmosphere at high temperatures has also been carried out (H. Jiang, J. et al., Trans. Nonferous Met. Soc. China 16 (2006) s419-422). Other authors have described the preparation of selenide nanoparticles from selenites in organic medium using high temperature (thus lowering selenite content) (US2007/0054435). The selenide nanoparticles thus obtained have been used for printing layers that have been transformed afterwards into chalcopyrites for photovoltaic applications.

None of the methods described in different publications have used compositions containing selenium dioxide and/or selenites, which have been reduced *in-situ* by means of further processing.

The best traditional techniques for the deposition of selenide layers use vacuum (co-evaporation or magnetronic sputtering). Despite the high photoelectric efficiency obtained with these techniques, their implementation over large surfaces has several disadvantages:
- High cost of the deposition facilities, including vacuum chambers, load locks and vacuum pumps, among others;
- Low processing performance, given that each substrate has to be directly exposed to the source of material for a time ranging between minutes and hours;
- Difficult to control deposition uniformity over large-size substrates, especially in cases in which several element flows have to be controlled. This may give rise to a deviation in the stoichiometry, and consequently to the failure of the entire device.

Several low-cost deposition alternatives have been proposed, by printing different compositions that do not require the use of a vacuum and, to a great extent, solve the uniformity problems, as the layer composition is predetermined by the composition of the ink. In this sense, compositions based on solutions whose viscosity is increased by adding cellulose derivatives have been described (US2008/044570), as well as oxide nanoparticle suspensions (EP1870943) and chalcogenides (WO2007/065096, US2007/054435, US2007/169811).

Some of these techniques have proven to be very highly efficient (as much as 12 %, EP1870943), but their reproducibility is not yet satisfactory. One of the problems with these techniques is the need to use binding agents or other additives to condition a satisfactory printing homogeneity. The thermal decomposition of these additives causes carbon contamination which could deteriorate the semiconductor properties of the layer. Alternatively, removing residual carbon by means of calcination at high temperatures in an oxidizing atmosphere facilitates the formation of stable gallium and indium oxides, which are very difficult to subsequently reduce or convert into chalcogenides. Both effects deteriorate the crystalline quality of the layer and, consequently, the efficiency of the device.

Efficient incorporation of gallium is of crucial importance for conditioning the band gap of these materials, and it is a challenge not only for the printing methods, but also for other promising low-cost deposition methods, such as electrodeposition, to which different solutions have been proposed (US2006/0151331, EP1861916A2).

Alternative deposition methods based on solutions have also been described (T. Todorov, et al., Chemistry of Materials 18 (2006) 3145*;* US6875661*;* WO2008/063190). In these cases, the biggest problem is the low thickness that can be reached with a single layer without cracking, which requires repeating the deposition and further processing cycles several times.

Apart from Cu(In,Ga)Se₂, there are many promising thin layer materials for use in selenium-based photovoltaic and electronic devices. Layers of elemental selenium may also be used in intermediate steps in the manufacture of Cu(In,Ga)Se₂ absorbers (F. Hergert et al., Journal of Physics and Chemistry of Solids 66 (2005, 1903*)* or other materials.

Another drawback of many of the methods in use, which is avoided by means of the present invention, is the use of flammable and/or toxic gases (such as H₂Se), the use of which on an industrial scale requires extreme security measures and expensive purification facilities.

### Brief description of the invention

In contrast with the methods based on the reduction reaction of selenium and other selenites for the deposition of selenide layers using baths, the present invention relates to ink compositions used for printing layers preferably containing selenium dioxide and/or metallic selenites, which are then converted into selenium and/or selenides.

Thus, the invention is based on the *in-situ* reduction reaction of selenium dioxide and/or metallic selenites in order to form elemental selenium or selenides. This reaction may be carried out in the presence of an organic additive in the composition, such as triethanolamine, for example. When heating the composition, layers of selenium are obtained from the printed layers:

32 SeO₂ + 2 C₆H₁₅NO₃ → 32 Se + 30 CO₂ + 24 H₂O + N₂ (I)

or selenides. In the case of trivalent elements such as indium or divalent elements such as copper, it would follow that:

¹¹/₃ In₂(SeO₃)₃ + 2 C₆H₁₅NO₃ → ¹¹/₃ In₂Se₃ + 12 CO₂ + 15 H₂O + N₂ (IIa)

11 CuSO₃ + 2 C₆H₁₅NO₃ → 11 CuSe + 12 CO₂ + 15 H₂O + N₂ (IIb)

These selenites, may have been previously produced by means of the reaction of a soluble selenite (or tellurite), for example sodium selenite, with soluble salt or salts of the ion or ions to be used:

3 SeO₃²⁻+ 2 Me³⁺→ Me₂(SeO₃)₃ (IIIa)

SeO₃²⁻+ Me²⁺→ MeSeO₃ (IIIb)

However, it should not be ruled out that, especially with the trivalent elements, and mainly in the case of indium, basic salts may be formed as a consequence of the presence of the hydroxylated complexes InOH²⁺ and In(OH)₂⁺ (*cf.* C.H. Baes and R.E. Mesmer, The Hydrolysis of Cations, Wiley-Interscience Publications, N.Y. 1978).

The present invention therefore relates to ink compositions for printing, that make it possible to print layers of selenides and other chalcogenides with a very uniform composition without the need for polymeric additives to facilitate homogeneous printing. Likewise, the obtained layers may be processed in an inert atmosphere, without the need to use toxic gasses, so as to produce, in the case of gallium, layers with excellent incorporation of all the metals present. In addition, the invention relates to the way in which these compositions are made to react with each other, *in-situ,* to give rise to the desired semiconductor.

Therefore, a first object of the present invention is an ink composition for the *in-situ* production of chalcogens and/or chalcogenides characterised in that it comprises at least one chalcogenite compound having a formula selected from a group consisting of SeO₂, M(SO₃)ₙ, M(SeO₃)ₙ and M(TeO₃)ₙ, wherein 0.5≤n≤2 and M is a metal element, preferably selected from the group Cu, In and Ga. Preferably, the chalcogenite consists of selenite.

Likewise, an object of the present invention is an ink for the *in-situ* production of chalcogens and/or chalcogenides consisting of a suspension or solution of said composition, as well as the use of said ink for the *in-situ* preparation of semiconductor materials by printing or depositing them in layers and the formation of chalcogens and/or chalcogenides from the compounds in the ink.

Additionally, an object of the invention is a method for preparing said ink. In a particular embodiment wherein the sole purpose is to produce a semiconductor material comprising at least one chalcogen element, said method is characterised it that it comprises mixing:
(a) 1 to 20 parts by weight of at least one chalcogenite having a formula selected between SeO₂, M(SO₃)ₙ, M(SeO₃)ₙ and M(TeO₃)ₙ, wherein 0.5≤n≤2 and M is a metal element, preferably selected from the group Cu, In and Ga (said chalcogenite preferably being selenite);
(b) 1 to 20 parts by weight of at least one organic reductant, preferably amine, and more preferably triethanolamine or monoethanolamine;
(c) 20 to 400 parts by weight of a solvent, preferably alcohol and more preferably ethanol.

This mixture is heated while stirring at a temperature preferably comprised between 0°C and 100°C until dissolving, said solution constituting the ink to be used.

The addition or modification of the chalcogen element content may optionally be carried out through processing in atmospheres containing vapours of said elements.

Alternatively, in a particular embodiment wherein the sole purpose is to produce a semiconductor material comprising at least one chalcogenide, the production method of the inks may comprise:
(a) preparing a first solution, optionally aqueous, of at least one chalcogenite compound having a formula selected from a group consisting of SeO₂, M(SO₃)ₙ, M(SeO₃)ₙ and M(TeO₃)ₙ, wherein 0.5≤n≤2 and M is at least one metal element;
(b) preparing a second, optionally aqueous, solution of at least one salt of a second metal element and adding an equimolecular amount of hydroxide solution (preferably sodium hydroxide) and an amount of water which is enough to reach a concentration of chalcogen between 1 mM and 2 M;
(c) mixing the first solution and the second solution until reaching an optimal precipitation pH, preferably between 3 and 7, giving rise to a chalcogenite precipitate;
(d) washing the precipitate produced in the previous step and dispersing it in a solvent, preferably an organic solvent, and more preferably alcohol; and
(e) adding at least one reductant compound, preferably an organic reductant, to the previous dispersion.

In a particular embodiment of the invention, this method may comprise the previous preparation of the chalcogenite compound by adding, in a suitable receptacle, over a suspension containing the acid or oxide of the selected chalcogen element, preferably selenium, an equimolecular amount of hydroxide solution, preferably sodium hydroxide, and the amount of water which is enough to reach a concentration of chalcogen between 1 mM and 2 M.

Preferably, the oxide may consist of selenium or tellurium dioxide, as well as other selenium or tellurium and oxygen derivatives. However, other alternative elements such as P, As, I, Br and Cl may be taken into account.

As cations, apart from the aforementioned Cu, Ga and In, or instead of them, the chalcogenide object of the method may contain one or more of the following elements: Sn, Zn, Cd, Sb, Ag, Au, Al, Na, K, Mg, Ca, Sr, Ba, B, V, Ti, Zr, Ge, Si, Pb, Tl, Ni, Co, Fe, Hg, V, Nb, Mn and/or Cr.

Complementary to the addition of the reductant, in any step of the method, preferably in step (e), it is possible to add at least one compound selected among organic compounds which do or do not have shimmering, binding, surfactant, wetting, levelling, degassing or viscosity modifying effects, as well as inorganic or organic solvents such as, though not limited to, alcohols and amines.

In a particular further embodiment of the invention, the composition may also comprise solid nanoparticles of the aforementioned metals or their compounds such as, though not limited to, selenites. Said nanoparticles may be prepared from soluble salts giving rise to precipitation with a solution of sodium selenite (*L. Vlaev and G. Gospodinov, Termochimica Acta 370 (2001), 15).* The resulting product, subjected to thermal processing, releases SeO₂ and metal oxides. With the aim of later forming uniform layers, from the deposition of the ink obtained from said composition, it is important that the nanoparticles have smaller dimensions than the thickness of the layer, said dimensions preferably being between 2 to 3,000 nm.

Likewise, an object of the invention is the use of the ink obtained from the described methods for the *in-situ* production of chalcogens and/or chalcogenides that give rise to layers of semiconductors. To this end, the ink is first distributed or deposited on the surface to be processed, preferably a glass substrate coated with molybdenum, although other substrates such as metal, ceramic, polymer or combinations thereof may be used. Preferably, the ink is deposited forming layers of liquid thickness between 1 to 100 µm. Next, the substrate and deposited layer are together subjected to thermal processing at least once. In a preferred embodiment of the invention, it is subjected to thermal processing twice: first, slow thermal processing, preferably between 80 °C to 400 °C, in controlled air or atmosphere and, subsequently, rapid thermal processing, preferably between 80 °C to 1,200°C in a controlled atmosphere, thus obtaining a semiconductor layer. Said thermal processing may be carried out in a furnace, on a hot plate or by infrared lighting. The obtained semiconductor layer consists of an oxygen-free chalcogenide layer, with semiconductor characteristics, that may preferably be used for producing solar panels.

Deposition over conductive substrates and, especially, over insulating substrates coated with conductive layers, is of particular interest for photovoltaic applications. For example, in order to manufacture a light-absorbing layer for manufacturing Cu(In,Ga)Se₂ solar cells, the composition of selenides may be printed over glass substrates coated with molybdenum, using a system allowing for the production of a layer approximately 50 microns thick before drying. The assembly is placed over a heating plate at 350 °C for a time period preferably between 0.5 s to 1 h. Optionally, said method is repeated, accumulating several layers until reaching the desired thickness (for example, between 100 nanometres to 50 micrometres) and then it is subjected to final thermal processing, preferably rapid thermal processing with a heating speed of between 100 to 500 °C/min up to 550-600 °C.

*Manufacture of photovoltaic devices*. A photovoltaic device may be produced from the panels whose production has been described, by depositing on top of said layer, another layer of an n-type semiconductor, preferably consisting of a compound of at least one metal from the group Cd, Zn or In, and a clear conductive layer containing oxide or a mixture of oxides of at least one metal selected from the group Zn, Al, In, Sn, Sb and Cd.

### Description of the drawings

- In Figure 1, a layer of selenium according to Example 1 is displayed.
- In Figure 2, the X ray diffractograms of samples prepared according to Example 2 are displayed. Selenite precipitate powder, a sample processed in air at 350 °C, and a sample subjected to rapid processing at 550 °C.
- In Figure 3, the Raman spectrum of the sample prepared in Example 2 is displayed.
- In Figure 4, the scanning electron micrographs of samples prepared according to Example 2 are displayed: (a) powder from precipitate in nanoparticle form; (b) a layer after processing in air at 350 °C and (c) the surface of a layer subjected to rapid thermal processing at 550 °C and (d) a cross-section of a layer subjected to rapid thermal processing at 550 °C.
- In Figure 5, a voltage-current curve of a sample prepared according Example 2 is displayed.

### Detailed description of the invention

Below, an especially preferred embodiment of the invention is described, by way of illustration and not limitation.

In this particular embodiment the production of Cu, In and Ga selenides is described, though the method described may be applied to other similar compounds, such as Cu, In and Ga tellurides, and others in which one or more of these elements are substituted.

This method uses the precipitation of nanoparticles of Cu, In and Ga selenides, taking advantage of their low solubility, and describes their use in ink to deposit layers of Cu(In,Ga)Se₂. Sulphates have been used as metal anions, although other soluble salts, such as nitrates, chlorides, acetates, iodides, bromides, etc. may be used:
*1. Preparation of the chalcogenite solution (solution A).* In a suitable receptacle, an equimolecular amount of hydroxide solution, preferably sodium hydroxide, and the amount of water which is enough to reach a concentration of chalcogen between 1 to 50 mM, are added to a suspension containing the acid or the oxide of the selected chalcogen element, preferably selenium.
*2. Preparation of the solution of Cu, In and Ga salts (solution B).* In order to prepare the solution of metal element salts, a mixture, preferably of Cu, In and Ga sulphates, is added to another receptacle with water, while stirring, at a molar ratio approximately equal to that of the chalcogenide to be produced. Optionally, it is possible to add to this solution some of the additional substances pointed out above. Finally, once the solution has been prepared, an equimolecular amount of hydroxide solution, preferably sodium hydroxide, and the amount of water which is enough to reach a concentration of chalcogen between 1 to 10 mM, are added.
*3. Precipitation of the constituent elements.* Once the salts have dissolved, preferably using the same reactor wherein solution B has been prepared, solution A is added dropwise until reaching a pH of 3-7. The obtained precipitate is filtered and washed with an alcoholic solvent, preferably ethanol.
*4. Production of the ink.* The obtained powder is dispersed in the alcoholic solvent and an organic reductant, preferably triethanolamine and, optionally, organic compounds having shimmering, binding, surfactant, wetting, levelling, degassing or viscosity modifying effects, are added.

Although the best results were obtained with selenium, it has not been ruled out that it could be substituted by other elements within its group, denominated chalcogens, which are understood, for the purposes of this specification, to be the elements of group 16 of the periodic table: oxygen, sulphur, selenium, tellurium and polonium, of which, for obvious reasons, oxygen and polonium are ruled out. Thus, although within this specification reference is made to selenium in particular, what is stated also refers implicitly to sulphur and tellurium.

### Examples

### Example 1. Composition containing selenium dioxide and use thereof for printing layers of selenium.

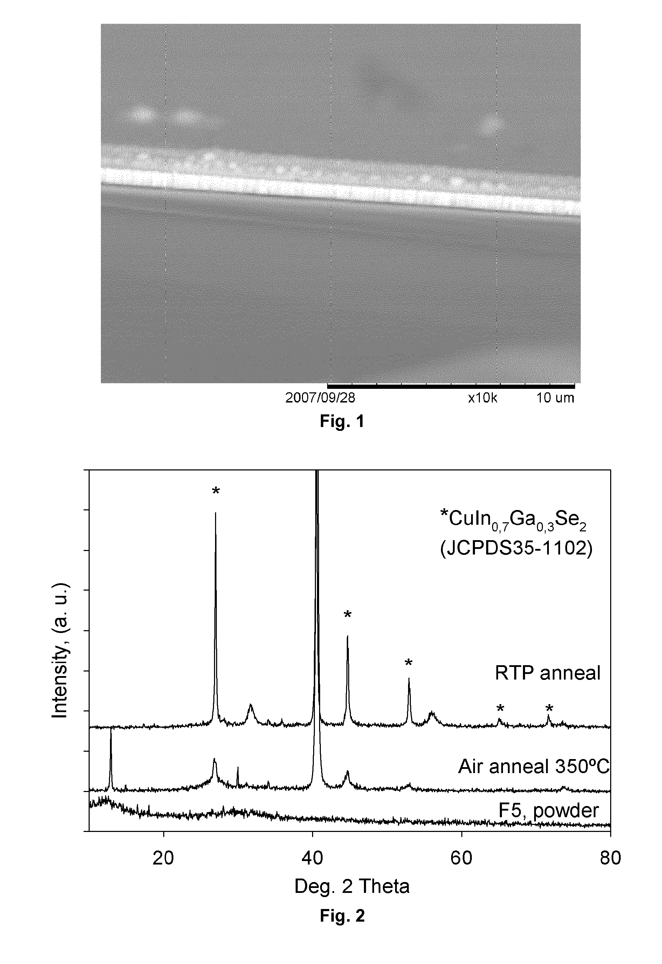

A mixture of ethanol 1.4 g, triethanolamine 0.1 g and SeO₂ 0.6 g was placed in a glass receptacle and heated at 70 °C, stirring the mixture until dissolved. A drop of the solution was distributed with the tip of a pipette on a glass substrate coated with molybdenum, which were together placed on an electric plate at 250-300 °C for 2 minutes. The layer acquired a red colour corresponding to the formation of elemental selenium. Figure 1 shows the cross-section of the obtained layer.

### Example 2. Composition containing nanoparticled Cu, In and Ga selenites and use thereof for printing Cu(In,Ga)Se₂.

Two solutions are prepared containing:
- (A) Na₂SeO₃ solution, by reacting 20 mmol H₂SeO₃ with 40 mmol NaOH in 25 ml H₂O.
- (B) Solution of the constituent metal cations: CuSO₄.5H₂O 0.88 g, Ga₂(SO₄)₃.18H₂O 0.3 g and In₂(SO₄)₃.6H₂O 0.615 g in 125 ml of water in a 250 ml beaker.

Solution A was added dropwise to solution B until a pH of 3-7 was reached. The precipitate was filtered and washed with ethanol.

The obtained powder was dispersed in ethanol and triethanolamine was added to the suspension. The composition thus obtained was deposited on a glass substrate coated with molybdenum using two 50 µm thick pieces of adhesive tape, attached in parallel on the substrate, and sliding a glass rod over them; the excess of the suspension was removed from the layer. The test piece thus obtained was placed on an electric plate at 350 °C for 2 minutes and then was subjected to rapid thermal processing using halogen radiation at a heating speed of 500 °C/min up to 550 °C.

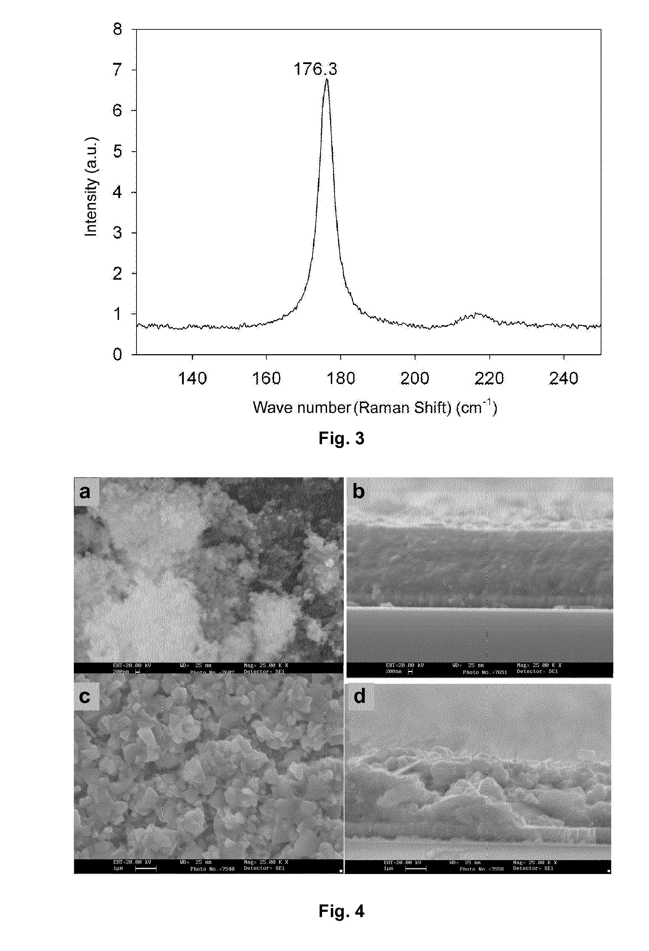

*Characterisation of the samples:* X ray diffraction analysis (Figure 2) showed that the powder was initially amorphous, whereas after the first calcination at 350 °C the desired phase begins to be seen, accompanied by other binary phases. The layers subjected to rapid thermal processing at 550 °C have excellent crystallinity and, apart from peaks from the substrate, present CuIn_{0.7}Ga_{0.3}Se₂, (JCPDS 35-1102). The efficient incorporation of the gallium was confirmed by Raman spectroscopy with the peak at 176.3 cm⁻¹ (Figure 3).

The thickness of the layer, determined by scanning electron microscopy, was approximately 3 µm (Figure 4).

### Example 3. Manufacture of a photovoltaic device according to the present invention.

Following the method similar to the one described in Example 2, layers of CuIn_{0.7}Ga_{0.3}Se₂ were deposited over glass coated with molybdenum. Upon the layer thus obtained, a 50-100 nm layer of cadmium sulphide was deposited using a solution containing thiourea, NH₃ and a Cd salt; on top of this, layers of ZnO and conductive ZnO doped with aluminium by means of magnetronic sputtering.

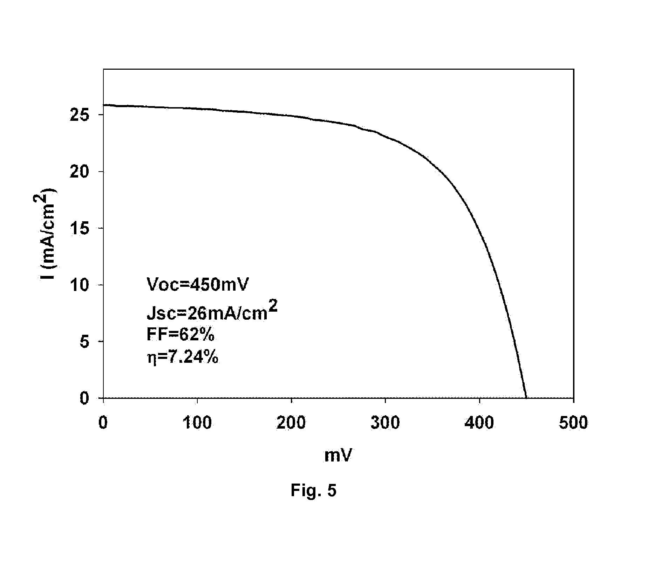

The current-voltage characteristic of a 0.1 cm² area was measured under simulated solar illumination. Efficiencies of 7.24 % were recorded with an open circuit voltage of 450 mV, a short circuit current of 26 mA/cm² and fill factor of 62 % (Figure 5). Furthermore, in some isolated tests, the voltage increased to 460 mV, and the efficiency to 7.5 %.

## Claims

1. Ink composition for the *in-situ* production of chalcogens and/or chalcogenides **characterised in that** it comprises at least one chalcogenite compound having a formula selected from a group consisting of SeO₂, M(SO₃)ₙ, M(SeO₃)ₙ and M(TeO₃)ₙ, wherein 0.5≤n≤2 and M is at least one metal element.

2. Composition, according to claim 1, wherein said metal element M is selected from a group consisting of Cu, In and Ga.

3. Composition, according to claim 1, wherein said metal element is selected from a group consisting of Sn, Zn, Cd, Sb, Ag, Au, Al, Na, K, Mg, Ca, Sr, Ba, B, V, Ti, Zr, Ge, Si, Pb, Tl, Ni, Co, Fe, Hg, V, Nb, Mn and Cr, as well as any combination thereof.

4. Ink for the *in-situ* production of chalcogens and/or chalcogenides consisting of a suspension or solution of a composition according to any one of the claims 1 to 3.

5. Method for preparing an ink for the *in-situ* production of chalcogens, according to claim 4, wherein said method is **characterised in that** it comprises mixing:
(a) 1 to 20 parts by weight of at least one chalcogenite compound having a formula selected from a group consisting of SeO₂, M(SO₃)ₙ, M(SeO₃)ₙ and M(TeO₃)ₙ, wherein 0.5≤n≤2 and M is at least one metal element;
(b) 1 to 20 parts by weight of at least one reductant; and
(c) 20 to 400 parts by weight of a solvent;
said mixture subsequently being heated while stirring at a temperature comprised between 0 °C to 100 °C until obtaining a solution constituting the ink to be prepared.

6. Method for preparing an ink for the *in-situ* production of chalcogenides, according to claim 4, wherein said method is **characterised in that** it comprises:
(a) preparing a first solution of at least one chalcogenite compound having a formula selected from a group consisting of SeO₂, M(SO₃)ₙ, M(SeO₃)ₙ and M(TeO₃)ₙ, wherein 0.5≤n≤2 and M is at least one metal element;
(b) preparing a second solution of at least one salt of a second metal element and adding an equimolecular amount of a hydroxide solution and an amount of water which is enough to reach a concentration of chalcogen between 1 mM to 2 M;
(c) mixing the first aqueous solution and the second aqueous solution until reaching a pH giving rise to a chalcogenite precipitate from the second metal element in the solution from step (b);
(d) washing the precipitate produced in the previous step and dispersing it in a solvent; and
(e) adding a reductant to the previous dispersion.

7. Method, according to claim 6, wherein the salt for preparing the second aqueous solution is selected from a group consisting of sulphate, nitrate, chloride, acetate, iodide and bromide of the second metal element.

8. Method, according to any one of the claims 5 to 7, wherein said reductant is an amine selected between triethanolamine and monoethanolamine.

9. Method, according to any one of the claims 5 to 8, wherein said solvent is an alcoholic solvent.

10. Method, according to any one of the claims 5 to 9, wherein the metal element M is selected from a group consisting of Cu, In and Ga, as well as any combination thereof.

11. Method, according to any one of the claims 5 to 10, wherein the second metal element is selected from a group consisting of Sn, Zn, Cd, Sb, Ag, Au, Al, Na, K, Mg, Ca, Sr, Ba, B, V, Ti, Zr, Ge, Si, Pb, Tl, Ni, Co, Fe, Hg, V, Nb, Mn and Cr, as well as any combination thereof.

12. Method, according to any one of the claims 5 to 11, wherein it comprises complementarily adding solid selenite nanoparticles with a particle size comprised between 2 to 2,000 nm.

13. Method, according to any one of the claims 5 to 12, wherein it comprises complementarily adding at least one compound selected from a group consisting of organic, binding, surfactant, wetting, levelling, degassing and viscosity modifying compounds, as well as inorganic or organic solvents.

14. Method, according to any one of the claims 6 to 13, wherein it comprises an additional step of preparing the chalcogenite compound by adding a suspension containing an acid or oxide of the chalcogen element, a hydroxide solution, and an amount of water which is enough to reach a concentration of chalcogen between 0.1 to 1,000 mM.

15. Ink obtainable through a method according to any one of the claims 5 to 14.

16. Use of an ink according to claim 4 or 15 for the *in-situ* preparation of a semiconductor material.

17. Method for preparing a semiconductor material **characterised in that** it comprises depositing an ink according to claim 4 or 15 on a substrate and applying thermal processing.

18. Method according to claim 17, wherein said thermal processing comprises a first thermal processing at a temperature comprised between 80 °C to 400 °C and a second thermal processing at a temperature between 80 °C to 1,200 °C.

19. Method according to claim 17 or 18, wherein the thermal processing is carried out in an atmosphere containing vapours of a chalcogen element or of a compound containing a chalcogen, wherein said chalcogen is selected between Se, S and Te.

20. Method, according to any one of the claims 17 to 19, wherein the deposition of the ink is carried out by printing or spraying.

21. Method, according to any one of the claims 17 to 20, wherein the substrate is selected from a group consisting of glass coated with molybdenum, metal, ceramic and polymer, or any combination thereof.

22. Method, according to any one of the claims 17 to 21, wherein the ink is deposited forming layers of between 1 to 100 µm thick.

23. Semiconductor material obtainable through a method according to any one of the claims 17 to 22.

24. Method for the manufacture of photovoltaic devices starting from a material according to claim 23, **characterised in that** it comprises depositing a first additional layer of at least one n-type semiconductor comprising at least one metal selected from the group Cd, Zn and In, and at least one second conductive and clear layer comprising an oxide or a mixture of oxides of at least one metal selected from the group Zn, Al, In, Sn, Sb and Cd.

25. Photovoltaic device obtainable through a method according to claim 24.
